# EUROPÄISCHE PATENTSCHRIFT

(11) **EP 2 017 868 B1**
(45) Veröffentlichungstag und Bekanntmachung des Hinweises auf die Patenterteilung: **22.10.2014**
(21) Anmeldenummer: 08017536.7
(22) Anmeldetag: 28.07.2006
(51) Int. Cl.: H01H 51/00, H02P 23/00, G05B 9/02, H01H 47/00, H03M 1/20, H01H 9/54

(54) **Dreiphasige Leistungsendstufe**
Three-phase power output stage
Etage de sortie de puissance triphasée

(30) Priorität: 02.08.2005 DE 102005036777; 23.09.2005 DE 102005045753; 12.01.2006 DE 102006001805
(43) Veröffentlichungstag der Anmeldung: 21.01.2009
(62) Teilanmeldung aus: 06762897.4
(73) Patentinhaber: Phoenix Contact GmbH & Co. KG, 32825 Blomberg (DE)
(72) Erfinder: Korrek, Andre, 37696 Marienmünster (DE)
(74) Vertreter: Blumbach Zinngrebe

(56) Entgegenhaltungen:
- DE-A1- 1 415 980
- DE-A1- 2 742 511
- DE-A1- 4 335 917
- DE-A1- 19 601 540
- DE-A1- 19 707 241
- DE-B- 1 227 109
- GB-A- 489 810

## Beschreibung

Die Erfindung betrifft eine dreiphasige Leistungsendstufe zum Ansteuern wenigstens einer Last, insbesondere eines Drehstrommotors gemäß dem Oberbegriff der unabhängigen Ansprüche.

Eine dreiphasige Leistungsendstufe gemäß dem Oberbegriff ist aus der DE 1 227 109 B bekannt.

Dreiphasige Leistungsendstufen sind hinlänglich bekannt und dienen dazu, den von einem Drehstromgenerator erzeugten Drehstrom in gesteuerter Weise Lasten zur Verfügung zu stellen. Die Lasten können an eine Phase oder an alle drei Phasen der Leistungsendstufe angeschaltet und somit mit Wechselstrom bzw. Drehstrom versorgt werden.

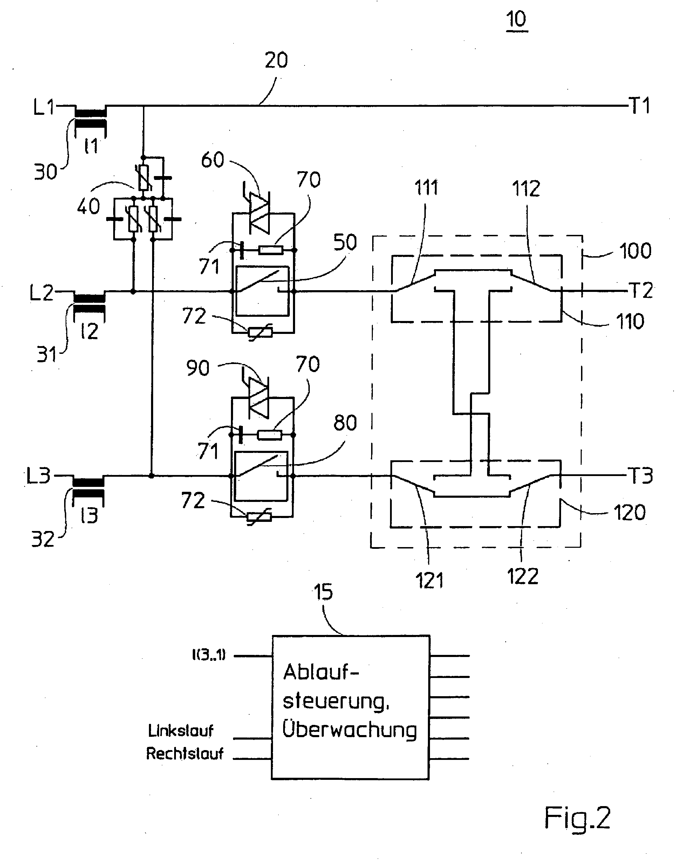

Eine bekannte dreiphasige Leistungsendstufe ist beispielsweise in Fig. 2 dargestellt. Die allgemein mit 10 bezeichnete Leistungsendstufe weist drei Leiter 20, 21 und 22, auch Phasen genannt, auf. In herkömmlicher Weise werden die zu einer nicht dargestellten Drehstromversorgungseinrichtung weisenden Leiterenden mit L1, L2 und L3 bezeichnet. Die Einspeisung eines Wechselstrom in die Leiter 30, 31 und 32 ist symbolisch durch einen Übertrager 30, 31 beziehungsweise 32 dargestellt. Um die elektronischen Bauelemente der Leitungsendstufe 10 und/oder die daran angeschalteten Lasten vor Überspannungen zu schützen, befindet sich zwischen den Leitern 20, 21 und 22 eine allgemein mit 40 bezeichnete Überspannungsschutzschaltung. Die Überspannungsschutzschaltung 40 kann mehrere Reihen- und/oder Parallelschaltungen aus Kondensatoren, Widerständen und/oder Varistoren aufweisen. Derartige Überspannungsschutzschaltungen sind bekannt und bedürfen somit keiner näher Erläuterung.

Die ausgangsseitigen Leiterenden werden in herkömmlicher Weise mit T1, T2 und T3 bezeichnet. Wie Fig. 2 zeigt, ist in den Leiter 21 ein Schaltkontakt 50 geschaltet, der Teil eines Relais ist. Parallel zum Schaltkontakt 50 ist ein als Wechselstromschalter fungierendes Halbleiterbauelement 60 geschaltet, welches durch einen Triac oder durch eine entsprechende Thyristor-Schaltung verwirklicht sein kann. Parallel zum Triac 60 ist eine Schutzschaltung vorgesehen, die eine Reihenschaltung aus einem Widerstand 70 und einem Kondensator 71 und einen parallel dazu geschalteten Varistor umfassen kann. Die Schutzschaltung dient dazu, den Triac 60 und/oder Optotriacs, die die Zündspannung für die Triacs liefern, vor Spannungsspitzen zu schützen. Es sei darauf hingewiesen, dass derartige Schutzschaltungen für Halbleiterschalter, wie zum Beispiel den Triac 60, bekannt sind und somit nicht weiter erläutert werden müssen.

In den Leiter 22 ist ebenfalls ein Schaltkontakt 80 geschaltet, der zu einem separaten Relais gehört. Parallel zum Schaltkontakt ist wiederum ein Halbleiterschalter 90 in Form eines Triacs sowie eine Schutzschaltung in Form einer Reihenschaltung aus einem Widerstand 70 und einem Kondensator 71 sowie einem parallel dazu geschalteten Varistor 72 vorgesehen. Weiterhin ist zwischen den zweiten und dritten Leiter 21 und 22 eine Wendeschalteinrichtung 100 vorgesehen, die ein dem Leiter 21 zugeordnetes Relais 110 und ein dem Leiter 22 zugeordnetes Relais 120 aufweist.

Das dem Leiter 21 zugeordnete Relais 110 weist zwei Schaltkontakte 111 und 112 auf, wohingegen das dem Leiter 22 zugeordnete Relais 120 Schaltkontakte 121 und 122 aufweist. Die Wendeschaltung 100 dient dazu, die Laufrichtung eines angeschlossenen Drehstrommotors zu ändern. Im dargestellten Schaltzustand verbinden die Schaltkontakte 111 und 112 des Relais 110 den Eingang L2 mit dem Ausgang T2 des Leiters 21, während die Schaltkontakte 121 und 122 des Relais 120 den Eingang L3 mit dem Ausgang T3 des Leiters 22 verbinden. Im angeschalteten Zustand dreht sich ein angeschlossener Drehstrommotor bei dieser Schaltkontaktstellung beispielsweise rechts herum. Werden die Relais 110 und 120 angesteuert, dann sorgen die jeweiligen Schaltkontakte 111 und 112 beziehungsweise 121 und 122 dafür, dass ein Wechselstrom über den Leiter 22 zum Ausgang des Leiters 21 und ein Wechselstrom vom Leiter 21 zum Ausgang des Leiters 22 geführt wird. Auf diese Weise wird die Laufrichtung eines angeschlossenen Drehstrommotors geändert.

Die bei der bekannten Leistungsendstufe eingesetzten Relais 110 und 120 der Wendeschaltung 110 sorgen dafür, dass die Leiter 21 und 22 ununterbrochen durchgeschaltet sind. Ein Abschalten der bekannten Leistungsendstufe 10 ist nur hinsichtlich der Leiter 21 und 22 möglich, indem die Schaltkontakte 50 und 80 geöffnet werden, so dass die den beiden Leitern zugeordneten Triacs 60 beziehungsweise 90 gesperrt betrieben werden. Da die Triacs allein einen Stromfluss durch die Leiter 21 und 22 sperren müssen, werden spezielle Halbleiterbauteile verwendet, die einer Sperrspannung von etwa 1200 V widerstehen können.

Die in Fig. 2 gezeigte bekannte Leistungsendstufe ist nicht geeignet, die Anforderungen der Sicherheitskategorie 3 zu erfüllen, da keine dreiphasige Abschaltung der Leistungsendstufe möglich ist. Denn in dem Leiter 20 ist kein Schalter vorgesehen, der den Leiter öffnen könnte.

Der Erfindung liegt die Aufgabe zugrunde, die eingangs genannte dreiphasige Leistungsendstufe derart weiter zu entwickeln, dass diese die Anforderungen der Sicherheitskategorie 3 sowie der Stop-Kategorien 0 und 1 erfüllt.

Ein Aspekt der Erfindung ist darin zu sehen, eine neuartige Wendeschalteinrichtung anzugeben, die die Verwendung von kostengünstigeren Halbleiterbauelementen für die bei der Leistungsendstufe eingesetzten Halbleiterschalter ermöglicht.

Dank der neuartigen Wendeschalteinrichtung werden die Halbleiterschalter nämlich im gesperrten Zustand niedrigeren Sperrspannungen, d.h. etwa 800 V ausgesetzt als bei der in Fig. 2 gezeigten Leistungsendstufe, bei der die Sperrspannungen bei etwa 1200 V liegen. Ferner können die bei der bekannten dreiphasigen Leistungsendstufe nach Fig. 2 vorgesehenen Schutzschaltungen für die Halbleiterschalter bei der neuartigen Leistungsendstufe entfallen.

Ein weiterer Aspekt der Erfindung ist darin zu sehen, eine dreiphasige Leistungsendstufe zu schaffen, die vollständig abschaltbar ist und somit den Anforderungen der Sicherheitskategorie 3 genügt. Hierzu ist erforderlich, dass jeder Leiter der dreiphasigen Leistungsendstufe abgeschaltet werden kann.

Ein weiterer Aspekt der Erfindung ist darin zu sehen, die elektrische Belastung der eingesetzten Halbleiterschalter im abgeschalteten Betrieb der Leistungsendstufe zu verringern. Hierzu wird eine besondere Wendeschalteinrichtung verwendet, bei der beispielsweise zwei jeweils zwei Schaltkontakte aufweisende Relais parallel zwischen zwei Leiter geschaltet sind, derart, dass bei einer vorbestimmten Schaltkontaktstellung die beiden Leiter aufgetrennt sind. Ein Stromfluss durch diese beiden Leiter wird demzufolge nicht, wie beim Stand der Technik, allein durch die verwendeten Halbleiterschalter, sondern hauptsächlich durch die elektromechanischen Schaltkontakte der Wendeschalteinrichtung blockiert.

Danach ist eine dreiphasige Leistungsendstufe zum Ansteuern wenigstens einer Last, insbesondere eines Drehstrommotors vorgesehen, die einen ersten, zweiten und dritten Leiter aufweist. Eingangsseitig kann die dreiphasige Leistungsendstufe mit einer Drehstromversorgungseinrichtung verbunden werden. Damit die dreiphasige Leistungsendstufe den Anforderungen der Sicherheitskategorie 3 sowie der Kategorie 0-Stop oder 1-Stop genügen kann, ist jedem Leiter wenigstens ein Schaltkontakt zum Öffnen und Schließendes jeweiligen Leiters zugeordnet. Um das dreiphasige Abschalten der Leistungsendstufe sicherer gewährleisten zu können, werden wenigstens zwei der Schaltkontakte, die verschiedenen Leitern zugeordnet sind, unabhängig voneinander angesteuert.

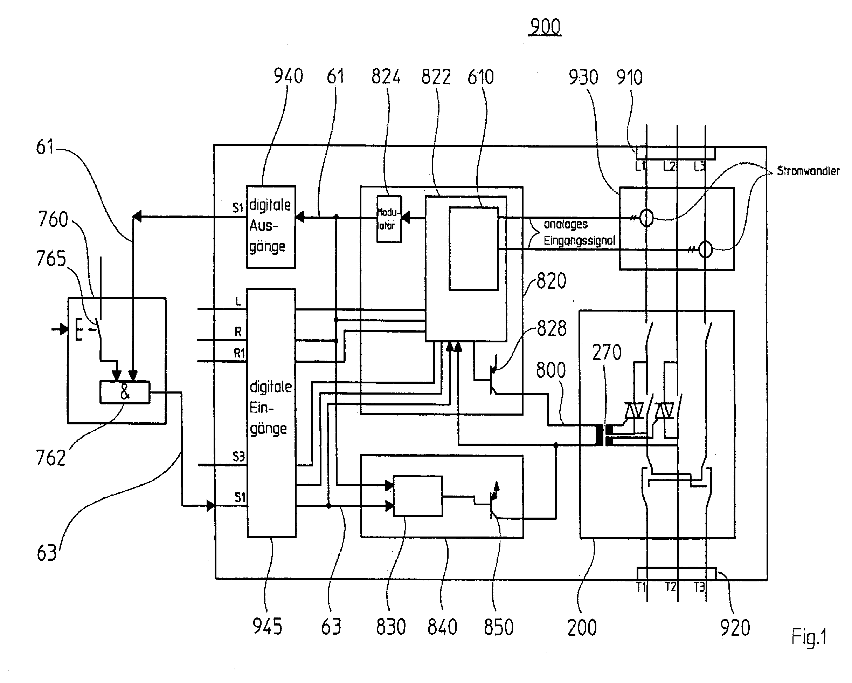

Um die Sperrspannung, die im abgeschalteten Zustand der dreiphasigen Leistungsendstufe an den Halbleiterschalter anliegt, reduzieren zu können - üblicherweise liegen 1000 V Sperrspannung an den Halbleiterschaltern an - ist zwischen zwei Leitern eine Wendeschalteinrichtung geschaltet, die zwei unabhängig voneinander ansteuerbare, jeweils einen ersten und zweiten Schaltkontakt aufweisende zweite Schaltelemente enthält, wobei die ersten Schaltkontakte der Schaltelemente an dem einen Leiter und die zweiten Schaltkontakte der Schaltelemente an dem anderen Leiter angeschaltet sind. In einer vorbestimmten Stellung der ersten und zweiten Schaltkontakte wird der Stromfluss durch die beiden Leiter gesperrt. Demzufolge lastet die Sperrfunktion nicht mehr ausschließlich bei den Halbleiterschaltern, sondern wird durch mechanische Schalter unterstützt. Demzufolge kann die Leistungsendstufe gegenüber der bekannten Leistungsendstufe nach Fig. 1 stromlos abgeschaltet werden.

An den zweiten und dritten Leiter ist jeweils ein Halbleiterschalter angeschlossen. Zwischen dem zweiten und dritten Leiter ist ein erstes Schaltelement mit einem ersten und zweiten Schaltkontakten geschaltet, wobei der erste Schaltkontakt parallel zu einem der Halbleiterschalter und der zweite Schaltkontakt parallel zum anderen Halbleiterschalter geschaltet sind. Bei dem ersten und zweiten Schaltkontakt kann es sich jeweils um den erwähnten ansteuerbaren Schaltkontakt gemäß Anspruch 1 handeln.

Gemäß einer ersten Alternative, die Gegenstand des Anspruchs 1 ist, sind die ersten Schaltkontakte der zweiten Schaltelemente der Wendeschalteinrichtung an dem zweiten Leiter und die zweiten Schaltkontakte der zweiten Schaltelemente an dem dritten Leiter angeschaltet. Ein drittes Schaltelement mit wenigstens zwei Schaltkontakten ist an den ersten Leiter angeschlossen.

Auf diese Weise ist sichergestellt, dass in jedem Leiter der dreiphasigen Leistungsendstufe mindestens zwei Schaltkontakte vorgesehen sind. Dadurch wird sichergestellt, dass die dreiphasige Leistungsendstufe die Stopp-Kategorie 0 und Stopp-Kategorie 1-Bedingungen erfüllt. Denn selbst bei Ausfall eines Schaltkontaktes ist ein sicheres dreiphasiges Abschalten der Leistungsendstufe immer noch möglich.

Eine zweite alternative Verschaltung der Wendeschalteinrichtung, die Gegenstand des Anspruchs 5 ist, sieht vor, dass die ersten Schaltkontakte der beiden zweiten Schaltelemente an dem ersten Leiter und die zweiten Schaltkontakte der beiden zweiten Schaltelemente an dem dritten Leiter angeschaltet sind.

Der Sicherheitsgrad kann beim Abschalten der Leistungsendstufe gemäß der zweiten Alternative gegenüber der ersten Alternative dadurch gesteigert werden, dass ein drittes Schaltelement mit einem ersten und zweiten Schaltkontakt vorgesehen ist, wobei der erste Schaltkontakt an den ersten Leiter und der zweite Schaltkontakt an den zweiten Leiter angeschlossen ist. Dadurch wird sichergestellt, dass in jedem Leiter jeweils zwei unabhängig voneinander ansteuerbare Schaltkontakte und Halbleiterschalter vorgesehen sind.

Vorteilhafte Weiterbildungen sind Gegenstand der Unteransprüche.

Wenigstens ein Schaltkontakt in jedem Leiter ist einem elektromagnetischen Schaltelement zugeordnet. Auf diese Weise ist sichergestellt, dass auch bei Verwendung von Halbleiterschaltern in dem zweiten und dritten Leiter, die Leiter mechanisch unterbrochen werden können. Da der Antrieb im abgeschalteten Zustand energiefrei ist, gibt es gegenüber der in Fig. 1 gezeigten Leistungsendstufe keine berührgefährlichen Spannungen.

Bei den Halbleiterschaltern kann es sich um Triacs, das sind Wechselstromschalter handeln, deren Zündenergie von einer Einrichtung bereitgestellt wird, die an eine Netzspannung angeschlossen ist. Die Einrichtung zum Bereitstellen der Zündenergie ist derart ausgebildet, dass sie die Halbleiterschalter für eine vorbestimmte Zeit im gezündeten Zustand hält, auch wenn zwischendurch der erste und zweite Schaltkontakt des ersten Schaltelements angesteuert wird. Dadurch wird sichergestellt, dass das zwischen dem zweiten und dritten Leiter angeordnete erste Schaltelement nahezu verschleißfrei geschaltet wird.

Dadurch, dass in der Leistungsendstufe vorzugsweise nur Relais mit jeweils zwei Schaltkontakten eingesetzt werden, bleibt die Anzahl verwendeter Relais gegenüber der in Fig. 1 gezeigten Leistungsendstufe bei deutlich verbesserter Sicherheit gleich.

Herkömmlicherweise sind die Halbleiterschalter durch jeweils eine Schutzeinrichtung vor Überspannungen und anderen elektrischen Störungen geschützt. An dieser Stelle sei darauf hingewiesen, dass die besondere Verschaltung der Wendeschalteinrichtung und die Verwendung eines elektromechanischen Schaltelements, dessen beide Schaltkontakte entweder in dem Leiter 1 oder jeweils in dem ersten und zweiten Leiter angeschlossen sind, einen Einsatz von Halbleiterschaltern auch ohne Schutzschaltungen ermöglichen.

In an sich bekannter Weise kann zwischen den drei Leitern eine Schutzschaltung gegen Überspannungen geschaltet sein.

Zum ordnungsgemäßen An- und Abschalten der dreiphasigen Leistungsendstufe ist eine Steuereinrichtung, gegebenenfalls auch eine programmierbare Steuereinrichtung, zum Ansteuern der Schaltelemente und Halbleiterschalter vorgesehen.

Um beim Auftreten eines Fehlers die dreiphasige Leistungsendstufe schnell und zuverlässig abschalten zu können, ist eine Überwachungseinrichtung vorgesehen, die den in den Leitern fließenden Strom, die zwischen den Leitern anliegende Ausgangsspannungen und/oder die Laufrichtung wenigstens eines angeschlossenen Drehstrommotors überwachen kann, wobei die Steuereinrichtung unter Ansprechen auf die Überwachungseinrichtung die jeweiligen Schaltelemente und Halbleiterschalter ansteuert.

Die Erfindung wird nachfolgend anhand mehrerer Ausführungsbeispiele in Verbindung mit den beiliegenden Zeichnungen näher erläutert. In den Zeichnungen werden für gleiche Bauteile oder Komponenten die gleichen Bezugszeichen verwendet. Es zeigen:
- Fig. 1: ein Sicherheitsschaltgerät gemäß der Erfindung,
- Fig. 2: eine dreiphasige Leistungsendstufe nach dem Stand der Technik,
- Fig. 3: eine gezeigte dreiphasige Leistungsendstufe gemäß der Erfindung,
- Fig. 4: eine alternative dreiphasige Leistungsendstufe gemäß der Erfindung,
- Fig. 5: eine schematische Darstellung einer dreiphasigen Leistungsendstufe ohne Verwendung einer Wendeschalteinrichtung,

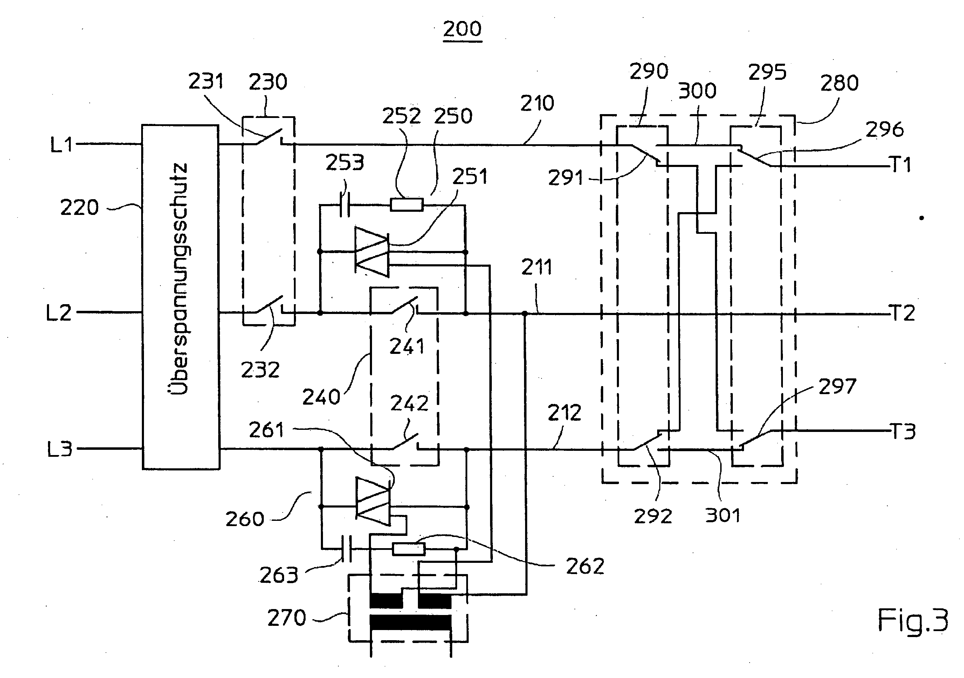

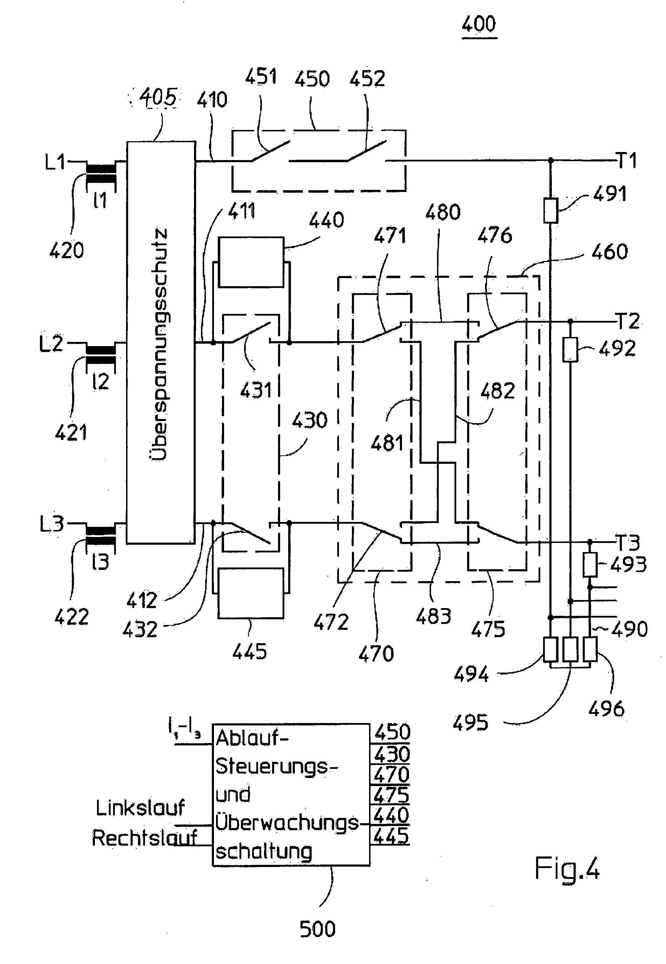

In Fig. 1 ist das Blockschaltbild eines beispielhaften Sicherheitsschaltgerät 900 dargestellt, dessen Komponenten in einem Gehäuse untergebracht sein können. Das Sicherheitsschaltgerät 900 weist eine erste Anschlusseinrichtung 910 auf, über die das Sicherheitsschaltgerät 900 beispielsweise an ein dreiphasiges Energieversorgungsnetz (nicht dargestellt) angeschaltet werden kann. Die drei mit dem Energieversorgungsnetz verbundenen Eingangsleiter sind in Fig. 1 mit L1, L2 und L3 bezeichnet. Die drei Leiter L1, L2 und L3 sind mit einer Leistungsendstufe 200 verbunden, deren drei ausgangsseitigen Leiter T1, T2 und T3 bezeichnet sind. Die drei ausgangseitigen Leiter sind mit einer zweiten Anschlusseinrichtung 920 verbunden, an die eine sicherheitstechnische Einrichtung, beispielsweise ein Drehstrommotor angeschlossen werden kann. Denkbar ist es, dass an das Sicherheitsschaltgerät 900 auch mehrere sicherheitstechnische Einrichtungen, wie z. B. ein- oder weitere mehrphasige Antriebe angeschlossen werden können. Dementsprechend ist die verwendete Leistungsendstufe ein-oder mehrphasig ausgebildet. Die Leistungsendstufe 200 ist der einfachen Darstellung wegen nur schematisch dargestellt. Die Leistungsendstufe 200 wird später im Zusammenhang mit Fig. 3 näher erläutert. An dieser Stelle sei angemerkt, dass anstelle der in Fig. 3 dargestellten Leistungsendstufe auch die in Fig. 4 dargestellte Leistungsendstufe 400 eingesetzt werden kann.

In die Eingangsleiter L1, L2 und L3 ist eine Einrichtung 930 mit Stromwandlern in den Leitern L1 und L3 geschaltet, die den analogen Strom in den Leitern L1 und L3 einer Messeinrichtung 610 zuführen. Die Messeinrichtung 610 kann Bestandteil einer programmierbaren Steuereinheit, zum Beispiel eines Mikrokontrollers oder Mikroprozessors 822 einer Steuereinrichtung 820 sein. Sie kann jedoch auch als separates Funktionsmodul ausgebildet sein. Hauptaufgabe der Messeinrichtung ist darin zu sehen, festzustellen, ob die Amplitude der Ströme in den Leitern L1 und L3 außerhalb eines vorbestimmten Arbeitsbereichs liegen. Wenn dies der Fall ist, steuert der Mikroprozessor 822 über einen Schalttransistor 828 die Leistungsendstufe 200 ab, um den angeschalteten Drehstrommotor von dem nicht dargestellten Energieversorgungsnetz zu trennen. Wie in der Fig. 1 schematisch dargestellt, ist der Schalttransistor 828 mit einem Übertrager 270 der Leistungsendstufe 200 verbunden. Alternativ oder zusätzlich ist es möglich, in die Leiter L1 und L3 Spannungswandler einzuschleifen, die Leiterspannungen der Messeinrichtung 610 zuführen. Die Messeinrichtung 610 kann derart ausgebildet sein, dass sie aus den empfangenen Spannungssignalen durch die Multiplikation mit den zugehörigen Stromsignalen die Wirkleistung ermittelt und prüft, ob die Wirkleistungen innerhalb oder außerhalb eines vorbestimmten Arbeitsbereichs liegen. Die tatsächlichen Werte des Arbeitsbereiches und die Zeitdauer, wie lange die Stromamplituden außerhalb des vorbestimmten Arbeitsbereiches liegen dürfen, ohne dass eine Abschaltung des Drehstrommotors erfolgt, können von einer Bedienperson eingestellt werden.

Weiterhin umfasst das Sicherheitsschaltgerät 900 eine weitere Steuereinrichtung 840 die einen Demodulator 840 und einen Schalttransistor 850 aufweist, der mit einem anderen Ende des Übertragers 270 der Leistungsendstufe 200 verbunden ist. Sowohl die Mikroprozessor gesteuerte Steuereinrichtung 820 als auch die Steuereinrichtung 840 sind Bestandteile einer mehrkanaligen Sicherheitsvorrichtung 810.

Dem Mikroprozessor 822 der ersten Mikroprozessor gesteuerten Steuereinrichtung 820 ist ein Modulator 824 zugeordnet, dessen Ausgangssignal über einen digitalen Ausgang einer Schnittstelle 940 einer extern an das Sicherheitsschaltgerät 900 angeschlossenen Eingangsstufe 760 zugeführt wird. Das Ausgangssignal der zweiten Steuereinrichtung 840 wird ebenfalls dem Mikroprozessor 822 zugeführt, der unter Ansprechen auf das empfangene Ausgangssignal die ordnungsgemäße Funktionsweise der zweiten Steuereinrichtung 840 überprüfen kann. Der Mikroprozessor 822 erzeugt in Verbindung mit dem Modulator 824 ein Überwachungssignal, welches signalisiert, ob die beiden Steuereinrichtungen 820 und 840 ordnungsgemäß arbeiten. Um sicherstellen zu können, dass der an das Sicherheitsschaltgerät 900 angeschaltete Drehstrommotor in einen sicheren Zustand gefahren werden kann, wenn entweder Schaltungskomponenten des Sicherheitsschaltgerätes 900, insbesondere die Steuereinrichtungen 820 und 840, defekt sind, oder von extern beispielsweise ein in der Eingangsstufe 760 implementierter Notausschalter 765 betätigt wird, wird sowohl das Eingangssignal des Notauschalters 765 als auch das Ausgangssignal des Modulators 824 einer Verknüpfungseinrichtung 762, welche beispielsweise ein Und-Gatter sein kann, zugeführt. Das Ausgangssignal der Verknüpfungseinrichtung 762 der Eingangsstufe 760 wird über eine Verbindung 63 einem digitalen Eingang einer Schnittstelle 945 des Sicherheitsschaltgerätes 900 zugeführt. Über die Schnittstelle 945 gelangt das Eingangssignal über einer Verbindung 63' zum Demodulator 830 der zweiten Steuereinrichtung 840 und zum Mikroprozessor 822. Erkennt der Demodulator 830 der Steuereinrichtung 840 oder der Mikroprozessor 822 der Steuereinrichtung 820, dass das vom Modulator 824 erzeugte Überwachungssignal einen Systemfehler signalisiert und/oder der Notausschalter 762 betätigt worden ist, so werden die jeweiligen Schalttransitoren 828 und 850 angesteuert, um die Leistungsendstufe 200 aufzutrennen, so dass die Energieversorgung über die Leiter L1, L2 und L3 zu den Ausgangsleitern T1, T2 und T3 und somit zum angeschlossenen Drehstrommotor unterbrochen wird.

An dieser Stelle sei angeführt, dass die in Fig. 1 gezeigte Eingangsstufe 760 lediglich der einfachen Darstellung wegen nur einen Schalter 765 enthält, der einen Notausschalter symbolisiert. Denkbar ist auch, einen Notausschalter mit mehreren Schaltern zu verwenden, wobei die Schalter in diesem Fall jeweils mit einem separaten Ausgang der Schnittstelle 940 und einem separaten Eingang der Schnittstelle 945 verbunden sein können. Ferner ist denkbar, dass die Eingangsstufe 760 alternativ oder zusätzlich zu einem Notausschalters, eine Schutztür, und/oder einen Zweihand-Schalter aufweisen kann. Je nach Ausführungsform werden die jeweiligen Ausgangssignale mit dem Überwachungssignal des Modulators 824 der Mikroprozessor gesteuerten Steuereinrichtung 828 in der Verknüpfungseinrichtung 762 verknüpft.

Dank dieser besonderen Maßnahmen ist das Sicherheitsschaltgerät 900 in der Lage, eine komplexe und vielfältige sicherheitstechnische Überwachung einer an das Sicherheitsschaltgerät 900 angeschalteten sicherheitstechnischen Einrichtung, beispielsweise eines Drehstrommotors zu übernehmen. In einer besonders zweckmäßigen Ausführungsform sind die Anschlußeinrichtungen 910 und 920, die Leistungsendstufe 200, die Bauteile der Steuereinrichtung 820 und 850 sowie die Schnittstellen 940 und 945 auf einer Leiterplatte (nicht dargestellt angeordnet. Demzufolge muß bei der Implementierung einer Anlage mit sicherheitstechnischen Einrichtungen lediglich dafür gesorgt werden, dass die sicherheitstechnische Einrichtung mit dem Sicherheitsschaltgerät 900 verbunden wird. Die Bedienperson muß sich nicht darum kümmern, wie die sicherheitstechnische Einrichtung an die jeweiligen Motorschutzschalter und Schutzrelais und ggfs. an einen Notauschalter angeschlossen werden muß. Die Gefahr von Fehlverdrahtungen ist somit deutlich gegenüber den bekannten Maßnahmen reduziert.

Weiterhin kann die Schnittstelle 945 zwei digitale Eingänge aufweisen, an die zwei Leitungen R und L angeschlossen sind, über die Steuersignale für den Rechts- oder Linkslauf eines Drehstrommotors angelegt werden können. Die Steuersignale werden ebenfalls dem Mikroprozessor 822 zugeführt, der die Leistungsendstufe entsprechend ansteuert. Die einzelnen Verbindungsleitungen sind der bessere Übersichtlichkeit wegen nicht in der Fig. 1 dargestellt. Weiterhin weist die Schnittstelle 945 einen weiteren Eingang R1 auf, an den ein nicht dargestellter Reset-Taster angeschlossen werden kann. Beispielsweise kann die Flanke eines angelegten Resetsignals vom Mikroprozessor 822 detektiert werden, der daraufhin die Leistungsendstufe 200 ansteuert, um nach Abschaltung des Drehstrommotors infolge eines Fehlers den Drehstrommotor wieder in Betrieb zu nehmen.

### Dreiphasige Leistungsendstufe

Fig. 3 zeigt die dreiphasige Leistungsendstufe mit drei Leitern 210, 211 und 212, die in dem Sicherheitsschaltgerät 900 eingesetzt werden kann. Die zu einer nicht dargestellten Drehstromversorgungseinrichtung weisenden Leiterenden tragen in herkömmlicherweise die Bezeichnungen L1, L2 und L3, während die entfernten Leiterenden die üblichen Bezeichnungen T1, T2 und T3 tragen. In der Nähe der Leiterenden L1, L2 und L3 befindet sich zwischen den drei Leitern 210, 211 und 212 eine an sich bekannte Überspannungsschutzschaltung 220, die ähnlich der in Fig. 2 gezeigten Schutzschaltung 40 aufgebaut sein kann. Zwischen den Leitern 210 und 211 ist ein elektromechanisches Schaltelement 230 geschaltet, welches im vorliegenden Beispiel ein Relais mit zwei Schaltkontakten 231 und 232 ist. Der Schaltkontakt 231 ist in den Leiter 210 geschaltet, während der Schaltkontakt 232 in den Leiter 211 geschaltet ist. Ein zweites elektromechanisches Schaltelement 240, welches im vorliegenden Beispiel wiederum ein Relais ist, ist zwischen dem Leiter 211 und dem Leiter 212 geschaltet. Das Relais 240 weist wiederum zwei Schaltkontakte 241 und 242 auf. Der Schaltkontakt 241 ist in den Leiter 211 geschaltet, während der Schaltkontakt 242 in den Leiter 212 geschaltet ist. Parallel zum Schaltkontakt 241 ist eine allgemein mit 250 bezeichnete Schalteinrichtung geschaltet, die als Halbleiterschaltelement einen Triac, also einen Wechselstromschalter, und eine dazu parallel geschaltete Reihenschaltung aus einem Widerstand 252 und einem Kondensator 253 aufweist, welche als Schutzschaltung für den Triac 251 fungiert. An dieser Stelle sei erwähnt, dass die besondere Schaltungsanordnung der dreiphasigen Leistungsendstufe 200 dazu führt, dass die Schutzschaltung nicht erforderlich ist. Der Grund hierfür wird weiter unten näher ausgeführt.

In ähnlicher Weise ist parallel zum Schaltkontakt 242 eine Schalteinrichtung 260 geschaltet, die ebenfalls einen Halbleiterschalter 261, welcher als Triac ausgebildet ist, aufweist. Ferner ist eine optionale Schutzschaltung parallel zu dem Halbleiterschalter 261 geschaltet. Die Schutzschaltung enthält wiederum beispielsweise einen Kondensator 263 und einen Widerstand 262. Die Zündenergie für die Triacs 251 und 261 wird beispielsweise von einem Übertrager 270 geliefert, der an einer Wechselspannung angeschlossen sein kann. In an sich bekannter Weise kann Die Zündenergie für die Triacs 251 und 261 kann in an sich bekannter Weise auch von einem Opto-Triac bereitgestellt werden. Als Halbleiterschalter 251 und 261 können anstelle von Triacs auch antiparallele Thyristoren verwendet werden.

Bereits an dieser Stelle sei erwähnt, dass ein Vorteil der in Fig. 3 gezeigten dreiphasigen Leistungsendstufe gegenüber der in Fig. 2 gezeigten bekannten Leistungsendstufe darin zu sehen ist, dass als Halbleiterbauelemente für die Halbleiterschalter 251 und 261 kostengünstigere Bauteile verwendet werden können, da die Halbleiterschalter 261 und 251 lediglich einer Sperrspannung von etwa 800 V ausgesetzt werden, während die Halbleiterschalter 60 und 90 Sperrspannungen von etwa 1200 V standhalten müssen. Ein Grund hierfür ist darin zu sehen, dass die Wendeschutzschaltung 100 gemäß der in Fig. 2 gezeigten Leistungsendstufe lediglich die Laufrichtung eines angeschlossenen, nicht dargestellten, Drehstrommotors steuert. Im Unterschied dazu wird in der Leistungsendstufe 200 nach Fig. 3 eine Wendeschalteinrichtung 280 verwendet, die nicht nur die Laufrichtung eines angeschlossenen Drehstrommotors wechseln kann, sondern auch der Abschaltung der Leistungsendstufe dient. Hierzu weist die Wendeschalteinrichtung 280 zwei elektromechanische Schaltelemente 290 und 295 auf, die parallel zwischen die Leiter 210 und 212 geschaltet sind. Beide Schaltelemente sind beispielsweise jeweils als Relais ausgebildet. Das Relais 290 weist zwei Schaltkontakte 291 und 292 auf, wobei der Schaltkontakt 291 an den Leiter 210 und der Schaltkontakt 292 an den Leiter 212 angeschaltet ist. Das Relais 295 weist ebenfalls zwei Schaltkontakte 296 und 297 auf. Der Schaltkontakt 296 ist mit dem Anschluss T1 des Leiters 210 verbunden, während der Schaltkontakt 297 mit dem Anschluss T3 des Leiters 212 verbunden ist. Dadurch, dass die Schaltelemente 290 und 295 zwischen den Leitern 210 und 212 angeordnet sind, können deren Schaltkontakte gegensinnig angesteuert werden, derart, dass die Wendeschaltung 280 in der dargestellten Stellung der Schaltkontakte 291, 292, 296 und 297 die Leiter 210 und 212 auftrennt. Ein Stromfluss durch die Leiter 210 und 212 wird somit mechanisch unterbrochen. Ein Stromfluss vom Leiteranfang L1 zum Leiterausgang T3 beziehungsweise vom Leiteranfang L3 zum Leiterausgang T1 wird dadurch erreicht, dass die Schaltkontakte 296 und 297 des Relais 295 nach innen geschaltet werden und dadurch mit gekreuzten Leiterabschnitten 302 bzw. 303 verbunden werden.

Werden hingegen die Schaltkontakte 291 und 292 des Relais 290 nach außen geschaltet, kontaktieren sie mit den Schaltkontakten 296 und 297 des Relais 295 die Leiterabschnitte 300 bzw. 301. Diese Stellung der Schaltkontakte sorgt für einen Stromfluss durch die Leiter 210 und 212 ermöglicht, sofern der Schaltkontakte 231 sowie der Schaltkontakt 242 geschlossen und/oder der Triac 261 gezündet ist.

Dank des Relais 230, der besonderen Verschaltung der Wendeschalteinrichtung 280 zwischen den Leitern 210 und 212, des Relais 240, welches in die Leiter 211 und 212 geschaltet ist, sowie der Halbleiterschalter 251 und 261, sind die Anforderungen der Sicherheitskategorie 3 für dreiphasige Leistungsendstufen sichergestellt, da ein dreiphasiges Abschalten der Leistungsendstufe 200 möglich ist. Ferner befinden sich beim vorliegenden Ausführungsbeispiel in jedem Leiter zumindest zwei mechanische Schaltkontakte, die sicheres Abschaltung der Leistungsendstufe auch dann erreichen werden, wenn ein Schaltkontakt oder ein Halbleiterschaltelement defekt ist. Da, wie bereits erwähnt, die Wendeschalteinrichtung 280 im Unterschied zu der in Fig. 2 gezeigten Wendeschalteinrichtung 100 eine Abschaltfunktionalität für die Leiter 210 und 212 besitzt, und ferner in dem Leiter 211 ein separater Schaltkontakt 232 angeordnet ist, liegen im abgeschalteten Zustand an den Halbleiterschaltelementen 251 und 261 niedrigere Sperrspannungen an als an den Halbleiterschaltelementen 60 und 90 der in Fig. 2 gezeigten Leistungsendstufe. Damit können kostengünstigere Bauelemente zur Realisierung der Halbleiterschaltelemente verwendet und auf eine Schutzbeschaltung verzichtet werden.

In Fig. 4 ist eine alternative Ausführungsform einer dreiphasigen Leistungsendstufe dargestellt, die allgemein mit 400 bezeichnet ist. Ähnlich der in Fig. 3 gezeigten Leistungsendstufe 200 weist die in Fig. 4 gezeigte Leistungsendstufe wiederum zumindest zwei mechanische Schaltkontakte in jedem Leiter auf. Auch die Leistungsendstufe 400 weist drei Leiter auf, die in Fig. 4 mit 410, 411 und 412 bezeichnet sind. Die Einspeisung der Wechselströme in die Leiter 410, 411 und 412 erfolgt beispielsweise über Übertrager 420, 421 und 422. Eingangsseitig ist ähnlich zu der in Fig. 3 dargestellten Leistungsendstufe 200 eine Überspannungsschutzschaltung 430 zwischen den Leitern 410, 411 und 412 angeschaltet. Ähnlich der in Fig. 3 gezeigten Leistungsendstufe 200 ist zwischen den Leiter 411 und 412 ein elektromechanisches Schaltelement in Form eines Relais 430 geschaltet, welches zwei Schaltkontakte 431 und 432 aufweist. Der Schaltkontakt 431 befindet sich im Leiter 411, während der zweite Schaltkontakt 432 sich im Leiter 412 befindet. Parallel zum Schaltkontakt 431 ist eine Schalteinrichtung 440 geschaltet, die ähnlich der in Fig. 3 dargestellten Schalteinrichtung 250 ein Halbleiterschaltelement, welches ein Triac sein kann, und optional eine Schutzschaltung aufweisen kann. In ähnlicher Weise parallel zum Schaltkontakt 432 eine Schalteinrichtung 445 geschaltet, die wiederum einen als Triac ausgebildeten Halbleiterschalter und optional dazu eine Schutzeinrichtung aufweisen kann. Im Unterschied zu der in Fig. 3 gezeigten Leistungsendstufe 200 ist in den Leiter 410 ein Relais 450 mit beispielsweise zwei Schaltkontakten 451 und 452 geschaltet. Im Unterschied zur Leistungsendstufe 200 nach Fig. 3 ist eine Wendeschalteinirchtung 460 nicht zwischen den ersten und dritten Leiter sondern zwischen den zweiten Leiter 411 und den dritten Leiter 412 geschaltet. Die Wendeschalteinrichtung 460 weist ähnlich der in Fig. 3 gezeigten Wendeschalteinrichtung 280 zwei elektromechanische Schaltelemente 470 und 475 in Form von Relais auf. Das Relais 470 weist wiederum zwei Schaltkontakte 471 und 472 auf, wobei der Schaltkontakt 471 mit dem Leiter 411 verbunden ist, während der Schaltkontakt 472 mit dem Leiter 412 verbunden ist. In ähnlicher Weise weist das Relais 475 zwei Schaltkontakte 476 und 477 auf. Der Schaltkontakt 476 ist mit dem Leiter 411 verbunden, während der Schaltkontakt 477 mit dem Leiter 412 verbunden ist. Die Wendeschalteinrichtung 460 weist weiterhin Leiterabschnitte 480, 481, 482 und 483 auf, an die die Schaltkontakte der Relais 470 und 475 angelegt werden können, um einen Wechsel des Stromflusses vom Leiter 411 zum Leiter 412 und umgekehrt, einen Durchfluss des Stroms durch die Leiter 411 und 412 sowie eine Sperrung des Stromflusses durch die Leiter 411 und 412 zu ermöglichen. Diese Funktionsweise wurde bereits an Hand der Leistungsendstufe 200 ausführlich erläutert. Die Schaltkontakte 471 und 472 des Relais 470 sowie die Schaltkontakte 476 und 477 des Relais 475 können wiederum gegensinnig angesteuert werden können, so dass mit der in Fig. 4 gezeigten Stellung der Schaltkontakte die Wendeschalteinrichtung 460 den Stromfluss durch die Leiter 411 und 412 mechanisch unterbrechen kann. Ausgangsseitig kann an die Leiter 410, 411 und 412 ein Spannungsdetektor 490 angeschlossen sein, über den die Ausgangsspannungen an den Leitern 410, 411 und 412 gemessen werden können. Hierzu bilden Widerstände 491 und 494 einen Spannungsteiler, der an den Leiter 410 angeschlossen ist, Widerstände 492 und 495 einen Spannungsteiler, der an den Leiter 411 angeschlossen ist, und Widerstände 493 und 496 einen Spannungsteiler, der an den Leiter 412 angeschlossen ist. In die Leiter 410, 411 und 412 kann jeweils ein Stromdetektor (nicht dargestellt) geschaltet sein, der den Strom in den jeweiligen Leitern messen kann. Die gemessenen Spannungs- und Stromwerte können einer Ablaufsteuerungs-und Überwachungseinrichtung 405 zugeführt werden. Ferner ist die Ablaufsteuerungs- und/oder Überwachungseinrichtung 405 mit den Schaltkontakten 431, 432, 451, 452, 471, 476, 472, 477 und den Halbleiterschaltern 440 und 445 verbunden. Die Schaltkontakte und Halbleiterschalter können gemäß einer programmierbaren Ablaufsteuerung oder unter Ansprechen auf einen gemessenen Spannungs- und/oder Stromwert, der einen Fehler der Leistungsendstufe 400 anzeigt, angesteuert werden. Ebenfalls kann die Ablaufsteuerungs- und/oder Überwachungseinrichtung 405 die Laufrichtung eines angeschlossenen Drehstrommotors überwachen.

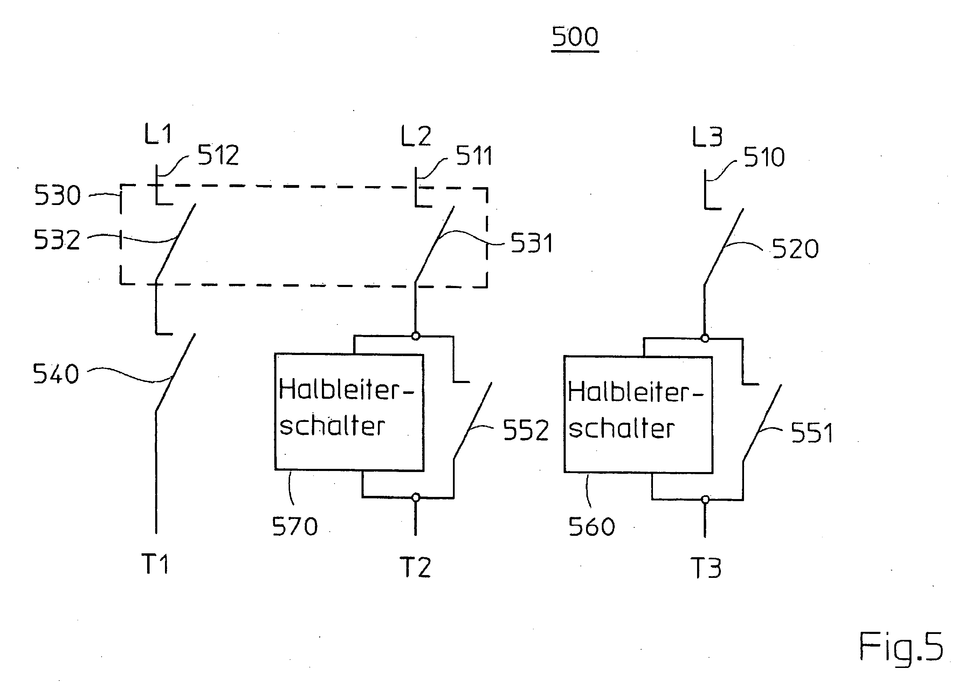

Für den Fall, dass ein angeschlossener Drehstrommotor nur in einer Laufrichtung betrieben werden soll, kann auf eine Wendeschalteinrichtung verzichtet werden. Eine entsprechende Leistungsendstufe ist in Fig. 5 schematisch dargestellt. Die dreiphasige Leistungsendstufe 500 weist wiederum drei Leiter 510, 511 und 512 auf. Damit auch die Leistungsendstufe 500 die Anforderungen der Sicherheitskategorie 3 erfüllen kann, ist in jeden Leiter wenigstens ein Schaltkontakt 520, 531 und 532 geschaltet. Um ein gesichertes dreiphasiges Abschalten der Leistungsendstufe 500 ermöglichen zu können, können wenigstens zwei Kontakte unabhängig voneinander angesteuert werden. Im vorliegenden Beispiel sind die Schaltkontakte 531 und 532 Teil eines elektromechanischen Schaltelementes 530, welches an die Leiter 511 und 512 angeschlossen ist. Der mit dem Leiter 510 verbundene Schaltkontakt 520 ist Bestandteil eines separaten Schaltelementes. Demzufolge kann der Schaltkontakt 520 gesondert und unabhängig von den Schaltkontakten 531 und 532 angesteuert werden. Um ein sicheres dreiphasiges Abschalten der Leistungsendstufe 500 auch bei Ausfall eines Schaltkontaktes gewährleisten zu können, sind in jedem Leiter zwei Schaltstufen vorgesehen. Die erste Schaltstufe enthält die Schaltkontakte 520, 531 und 532. Die zweite Schaltstufe weist einen Schaltkontakt 540 im Leiter 512, einen Schaltkontakte 551 im Leiter 510 und einen Schaltkontakt 552 im Leiter 511 auf. Parallel zu den Schaltkontakten 551 und 552 können Halbleiterschalter 560 und 570 geschaltet sein, die vorzugsweise wieder aus Triacs aufgebaut sind. Zweckmäßigerweise gehören die Schaltkontakte 551 und 552 zu einem Relais.

Die in den Fig. 3, 4 und 5 dargestellten Leistungsendstufen zeichnen sich dank der Verwendung elektromechanischer Schaltelemente durch eine große Robustheit gegen Störungen und durch geringe thermische und elektrische Verluste der Halbleiterschalter aus.

Nachfolgend wird die Funktionsweise der dreiphasigen Leistungsendstufe in Verbindung mit der in Fig. 4 dargestellten Ausführungsvariante näher erläutert.

Zunächst wird die Einschaltphase der Leistungsendstufe beschrieben. Im ersten Schritt werden über die Ablaufsteuerungs- und Überwachungseinrichtung 405 die beiden Schaltkontakte 451 und 452 des Relais 450 geschlossen. Demzufolge besteht ein geschlossener Strompfad über den Leiter 410. Je nachdem, in welcher Laufrichtung ein angeschalteter Drehstrommotor betrieben werden soll, werden entweder die Schaltkontakte 471 und 472 des Relais 470 eingeschaltet, um einen Linkslauf zu erreichen, oder die Schaltkontakte 476 und 477 des Relais 475 geschaltet, um einen Rechtslauf des Drehstrommotors zu erreichen. Werden die Schaltkontakt 471 und 472 nach innen geschaltet, so wird der in den Leiter 411 eingespeiste Wechselstrom über den Schaltkontakt 471 den Leiterabschnitt 481, den Schaltkontakt 477 zum Leiteranschluss T3 des Leiters 412 geführt, während ein in den Leiter 412 eingespeister Wechselstrom über den Schaltkontakt 472, den Leiterabschnitt 482 über den Schaltkontakt 476 zum Leiteranschluss T2 des Leiters 411 geführt wird. Werden hingegen die Schaltkontakte 476 und 475 angesteuert, so findet kein Stromwechsel zwischen den Leitern 411 und 412 statt.

Nach etwa 20 ms werden die Halbleiterschalter 440 und 445 über eine nicht dargestellte Energieversorgungseinrichtung gezündet. Beispielsweise können die Halbleiterschalter 440 und 445 über den in Fig. 3 dargestellten Übertrager 270 mit Zündenergie versorgt werden. Nach weiteren 20 ms werden die Schaltkontakte 431 und 432 des Relais 430 geschlossen. Es sei darauf hingewiesen, dass die angegebenen Zeitspannen lediglich beispielhaft zu verstehen sind. Vorzugsweise sind die Zeitdauern sogar kürzer. Ebenfalls ist es denkbar, die Schaltkontakte 431 und 432 gleichzeitig mit der Zündung der Triacs 440 und 445 zu schließen.

Für den vorliegenden Fall sei angenommen, dass die Schaltkontakte 476 und 477 des Relais 475 nach außen geschaltet worden sind, so dass nunmehr durchgeschaltete Leiter 411 und 412 vorliegen. Nachdem die Schaltkontakt 431 und 432 geschlossen worden sind, kann die Zündenergie von den Halbleiterschaltelementen 440 und 445 wieder abgeschaltet werden. Da die Halbleiterschalter 440 und 445 nur noch für eine kurze Zeitspanne, vorzugsweise weniger als 20 ms einen einfachen Wechselstrom schalten müssen, können entsprechend kostengünstige Halbleiter zur Realisierung der Triacs verwendet werden. Aus diesem Grund kann auch eine Schutzbeschaltung der Triacs 440 und 445 entfallen.

Nunmehr wird das ordnungsgemäße Abschalten der Leistungsendstufe 400 beschrieben. Zunächst werden die Halbleiterschalter 440 und 445 wieder gezündet und anschließend die Schaltkontakte 431 und 432 des Relais 430 geöffnet. Der Stromfluss erfolgt nunmehr kurzfristig, in der Regel für weniger als 20 ms, über die Halbleiterschaltelemente 440 und 445. Nach etwa 20 ms wird die Zündenergie von den Halbleiterschaltern 440 und 445 abgetrennt, wodurch der Antrieb eines angeschlossenen Drehstrommotors abgeschaltet wird. Nach weiteren beispielsweise 20 ms werden die Schaltkontakte 451 und 452 geöffnet und die Schaltkontakte 476 und 477 der Wendeschaltung 460 wieder nach innen geschaltet, so dass sie nunmehr wieder mit einem Ende des Leiterabschnitts 482 beziehungsweise 481 verbunden sind. Die Wendeschalteinrichtung 460 befindet sich demzufolge wieder im Sperrzustand.. Alle drei Leiter der dreiphasigen Leistungsendstufe 400 sind nunmehr geöffnet und ein sicherer Abschaltzustand ist erreicht.

Während des Betriebs werden die Ströme in den Leitern 410, 411 und 412 sowie die an den Leitern anliegenden Ausgangsspannungen von der Ablaufsteuerungs- und Überwachungseinrichtung überwacht. Sobald die Ablaufsteuerungs- und Überwachungseinrichtung 405 einen Störfall erkennt, werden beispielsweise die Schaltkontakte 451 und 452 im Leiter 410 sowie beispielsweise die Schaltkontakte 476 und 475 und die Schaltkontakte 471 und 471 in den in Fig. 3 gezeigten Schaltzustand versetzt, so dass eine dreiphasige mechanische Abschaltung sicher erfolgen kann.

Die Funktionsweise und Ansteuerung der Schaltkontakte der in Fig. 3 gezeigten dreiphasigen Leistungsendstufe 200 entspricht im Wesentlichen der Funktionsweise und Schaltweise der in Fig. 4 dargestellten und oben beschriebenen Leistungsendstufe 400. Die in Fig. 3 gezeigte Leistungsendstufe zeichnet sich gegenüber der in Fig. 4 gezeigten Leistungsendstufe 400 dadurch aus, dass auch bei Weglassen des Relais 230 eine dreiphasige Abschaltung der Leistungsendstufe erfolgen kann, da in jedem Leiter wenigstens ein Schalter in Form eines mechanischen Schaltkontaktes oder eines Halbleiterschalters vorgesehen ist.

## Patentansprüche

1. Dreiphasige Leistungsendstufe zum Ansteuern wenigstens einer Last, insbesondere eines Drehstrommotors, mit einem ersten, zweiten und dritten Leiter (410, 411, 412) der eingangsseitig mit einer Drehstromversorgungseinrichtung verbindbar ist, wobei jedem Leiter wenigstens ein ansteuerbarer Schaltkontakt (451, 431, 432) zum Öffnen und Schließen des jeweiligen Leiters zugeordnet ist, wobei die Ansteuerung von wenigstens zwei der Schaltkontakte unabhängig voneinander erfolgt, und ferner mit einer zwischen zwei Leiter geschaltete Wendeschalteinrichtung (460), die zwei unabhängig voneinander ansteuerbare, jeweils einen ersten und zweiten Schaltkontakt aufweisende zweite Schaltelemente (470, 475) enthält, wobei die ersten Schaltkontakte (471, 476) der zweiten Schaltelemente (470, 475) an dem einen Leiter (411) und die zweiten Schaltkontakte (472, 477) der zweiten Schaltelemente (470, 475) an dem anderen Leiter (412) angeschaltet sind, und wobei in einer vorbestimmten Stellung der ersten und zweiten Schaltkontakte eine Sperrung des Stromflusses durch die beiden Leiter (411, 412) erfolgt, wobei die ersten Schaltkontakte (471, 476) der zweiten Schaltelemente (470, 475) an dem zweiten Leiter (411) und die zweiten Schaltkontakte (472, 477) der zweiten Schaltelemente (470 475) an dem dritten Leiter (412) angeschaltet sind,
**dadurch gekennzeichnet, dass**
an dem zweiten und dritten Leiter (411, 412;) jeweils ein Halbleiterschalter (440, 445) angeschaltet ist, dass zwischen dem zweiten und dritten Leiter ein erstes Schaltelement (430) mit einem ersten und zweiten Schaltkontakt (431, 432) geschaltet ist,
der erste Schaltkontakt (431) parallel zu einem der Halbleiterschalter (440) und der zweite Schaltkontakt (432) parallel zum anderen Halbleiterschalter (445) geschaltet sind,
und dass
ein drittes Schaltelement (450) mit wenigstens zwei Schaltkontakten (451, 452) an dem ersten Leiter (410) angeschlossen ist.

2. Dreiphasige Leistungsendstufe nach Anspruch 1,
**dadurch gekennzeichnet, dass**
wenigstens ein Schaltkontakt (231, 232, 242) in jedem Leiter (210, 211, 212) Teil eines elektromagnetischen Schaltelementes (230, 240) ist.

3. Dreiphasige Leistungsendstufe nach Anspruch 1,
**gekennzeichnet durch**
eine Einrichtung (270) zum Bereitstellen einer vorbestimmten Zündenergie für die Halbleiterschalter (251, 261).

4. Dreiphasige Leistungsendstufe nach Anspruch 1,
**dadurch gekennzeichnet, dass**
parallel zu jedem Halbleiteschalter eine Schutzeinrichtung geschaltet ist.

5. Dreiphasige Leistungsendstufe zum Ansteuern wenigstens einer Last, insbesondere eines Drehstrommotors, mit einem ersten, zweiten und dritten Leiter (210, 211, 212) der eingangsseitig mit einer Drehstromversorgungseinrichtung verbindbar ist, wobei jedem Leiter wenigstens ein ansteuerbarer Schaltkontakt (231, 232, 242) zum Öffnen und Schließen des jeweiligen Leiters zugeordnet ist, wobei die Ansteuerung von wenigstens zwei der Schaltkontakte unabhängig voneinander erfolgt, und ferner mit einer zwischen zwei Leiter geschaltete Wendeschalteinrichtung (280), die zwei unabhängig voneinander ansteuerbare, jeweils einen ersten und zweiten Schaltkontakt aufweisende zweite Schaltelemente (290, 295) enthält, wobei die ersten Schaltkontakte (291, 296) der zweiten Schaltelemente (290, 295) an dem einen Leiter (210) und die zweiten Schaltkontakte (292, 297) der zweiten Schaltelemente (290, 295) an dem anderen Leiter (212) angeschaltet sind, und wobei in einer vorbestimmten Stellung der ersten und zweiten Schaltkontakte eine Sperrung des Stromflusses durch die beiden Leiter (210, 212) erfolgt,
**dadurch gekennzeichnet, dass**
an dem zweiten und dritten Leiter (211, 212) jeweils ein Halbleiterschalter (251, 261) angeschaltet ist, zwischen dem zweiten und dritten Leiter ein erstes Schaltelement (240) mit einem ersten und zweiten Schaltkontakt (241, 242) geschaltet ist,
der erste Schaltkontakt (241) parallel zu einem der Halbleiterschalter (251) und der zweite Schaltkontakt (242) parallel zum anderen Halbleiterschalter (261) geschaltet sind,
die ersten Schaltkontakte (291, 296) der beiden zweiten Schaltelemente (290, 295) der Wendeschalteinrichtung (280) an dem ersten Leiter (210) und die zweiten Schaltkontakte (292, 297) der beiden zweiten Schaltelemente (290, 295) an dem dritten Leiter (212) angeschaltet sind, dass
ein drittes Schaltelement (230) mit einem ersten und zweiten Schaltkontakt (231, 232) vorgesehen ist, und dass der erste Schaltkontakt (231) an dem ersten Leiter (210) und der zweite Schaltkontakt (232) an dem zweiten Leiter (211) angeschlossen ist.

6. Dreiphasige Leistungsendstufe nach einem der Ansprüche 1 bis 5,
**dadurch gekennzeichnet, dass**
die Schaltelemente Relais sind.

7. Dreiphasige Leistungsendstufe nach einem der Ansprüche 1 bis 6,
**dadurch gekennzeichnet, dass**
eingangsseitig zwischen die drei Leiter eine Schutzschaltung (220; 430) gegen Überspannungen geschaltet ist.

8. Dreiphasige Leistungsendstufe nach einem der vorgenannten Ansprüche,
**gekennzeichnet durch** eine programmierbare Steuereinrichtung (405) zum Ansteuern der Schaltelemente und Halbleiterschalter.

9. Dreiphasige Leistungsendstufe nach einem der vorgenannten Ansprüche,
**gekennzeichnet durch** eine Überwachungseinrichtung (405) zum Überwachen der Laufrichtung wenigstens eines angeschlossenen Drehstrommotors, der **durch** die Leiter fließenden Ströme und/oder der zwischen den Leitern anliegenden Ausgangsspannungen, wobei die Steuereinrichtung unter Ansprechen auf die Überwachungseinrichtung die jeweiligen Schaltelemente und/oder Halbleiterschalter ansteuert.

## Claims

1. A three-phase power output stage for driving at least one load, in particular a three-phase motor, comprising a first, second, and third conductor (410, 411, 412) connectable at an input side to a three-phase power supply unit, wherein each conductor has associated therewith at least one controllable switching contact (451, 431, 432) for opening and closing the respective conductor, wherein at least two of the switching contacts are controlled independently from each other, and further comprising a reversing switch means (460) connected between two conductors, which comprises two second switching elements (470, 475) controllable independently from each other and each having a first and second switching contact, wherein the first switching contacts (471, 476) of the second switching elements (470, 475) are connected to the one conductor (411) and the second switching contacts (472, 477) of the second switching elements (470, 475) to the other conductor (412), and wherein in a predetermined position of the first and second switching contacts, current flow through the two conductors (411, 412) is blocked; wherein the first switching contacts (471, 476) of the second switching elements (470, 475) are connected to the second conductor (411) and the second switching contacts (472, 477) of the second switching elements (470, 475) to the third conductor (412),
**characterized in that**
a semiconductor switch (440, 445) is connected to each of the second and third conductors (411, 412);
**in that** a first switching element (430) including a first and second switching contact (431, 432) is connected between the second and third conductors;
the first switching contact (431) is connected in parallel to one of the semiconductor switches (440) and the second switching contact (432) is connected in parallel to the other semiconductor switch (445);
and **in that** a third switching element (450) including at least two switching contacts (451, 452) is connected to the first conductor (410).

2. The three-phase power output stage according to claim 1, **characterized in that**
at least one switching contact (231, 232, 242) in each conductor (210, 211, 212) is part of an electromagnetic switching element (230, 240).

3. The three-phase power output stage according to claim 1, **characterized by**
a means (270) for providing a predetermined ignition energy for the semiconductor switches (251, 261).

4. The three-phase power output stage according to claim 1, **characterized in that**
a protection device is connected in parallel to each semiconductor switch.

5. A three-phase power output stage for driving at least one load, in particular a three-phase motor, comprising a first, second, and third conductor (210, 211, 212) connectable at an input side to a three-phase power supply unit, wherein each conductor has associated therewith at least one controllable switching contact (231, 232, 242) for opening and closing the respective conductor, wherein at least two of the switching contacts are controlled independently from each other, and further comprising a reversing switch means (280) connected between two conductors, which comprises two second switching elements (290, 295) controllable independently from each other and each having a first and second switching contact, wherein the first switching contacts (291, 296) of the second switching elements (290, 295) are connected to the one conductor (210) and the second switching contacts (292, 297) of the second switching elements (290, 295) to the other conductor (212), and wherein in a predetermined position of the first and second switching contacts, current flow through the two conductors (210, 212) is blocked;
**characterized in that**
a semiconductor switch (251, 261) is connected to each of the second and third conductors (211, 212);
a first switching element (240) including a first and second switching contact (241, 242) is connected between the second and third conductors;
the first switching contact (241) is connected in parallel to one of the semiconductor switches (251) and the second switching contact (242) is connected in parallel to the other semiconductor switch (261);
the first switching contacts (291, 296) of the two second switching elements (290, 295) of the reversing switch means (280) are connected to the first conductor (210) and the second switching contacts (292, 297) of the two second switching elements (290, 295) to the third conductor (212);
that a third switching element (230) including a first and second switching contact (231, 232) is provided; and **in that** the first switching contact (231) is connected to the first conductor (210) and the second switching contact (232) to the second conductor (211).

6. The three-phase power output stage according to any of claims 1 to 5, **characterized in that**
the switching elements are relays.

7. The three-phase power output stage according to any of claims 1 to 6, **characterized in that**
an overvoltage protection circuit (220; 430) is connected between the three conductors at the input side.

8. The three-phase power output stage according to any of the preceding claims,
**characterized by** a programmable control means (405) for controlling the switching elements and semiconductor switches.

9. The three-phase power output stage according to any of the preceding claims,
**characterized by** a monitoring means (405) for monitoring the running direction of at least one connected three-phase motor, of the currents flowing through the conductors, and/or of the output voltages existent between the conductors, wherein the control means controls the respective switching elements and/or semiconductor switches in response to said monitoring means.

## Revendications

1. Etage triphasé de sortie de puissance pour la commande d'au moins une charge, en particulier d'un moteur triphasé, avec un premier, un deuxième et un troisième conducteurs (410, 411, 412) pouvant être reliés à un dispositif d'alimentation en courant triphasé côté entrée, au moins un contact de commutation (451, 431, 432) pouvant être commandé étant affecté à chaque conducteur pour l'ouverture et la fermeture du conducteur correspondant, au moins deux contacts de commutation étant commandés indépendamment l'un de l'autre, et avec en outre un dispositif inverseur (460) monté entre deux conducteurs, comprenant deux deuxièmes éléments de commutation (470, 475) pouvant être commandés indépendamment l'un de l'autre, présentant chacun un premier et un deuxième contacts de commutation, les premiers contacts de commutation (471, 476) des deuxièmes éléments de commutation (470, 475) étant reliés au premier conducteur (411) et les deuxièmes contacts de commutation (472, 477) des deuxièmes éléments de commutation (470, 475) à l'autre conducteur (412), et une interruption du flux de courant par les deux conducteurs (411, 412) étant obtenue dans une position prédéfinie des premiers et deuxièmes contacts de commutation, les premiers contacts de commutation (471, 476) des deuxièmes éléments de commutation (470, 475) étant reliés au deuxième conducteur (411) et les deuxièmes contacts de commutation (472, 477) des deuxièmes éléments de commutation (470, 475) étant reliés au troisième conducteur (412),
**caractérisé :**
**en ce que** un interrupteur semi-conducteur respectif (440, 445) est relié aux deuxième et troisième conducteurs (411, 412),
**en ce que**, entre les deuxième et troisième conducteurs, un premier élément de commutation (430) est relié à des premier et deuxième contacts de commutation (431, 432), le premier contact de commutation (431) étant monté en parallèle à un des interrupteurs semi-conducteurs (440) et le deuxième contact de commutation (432) en parallèle à l'autre interrupteur semi-conducteur (445), et
**en ce que** un troisième élément de commutation (450) est relié au premier conducteur (410) par au moins deux contacts de commutation (451, 452).

2. Etage triphasé de sortie de puissance selon la revendication 1,
**caractérisé en ce que** :
au moins un contact de commutation (231, 232, 242) de chaque conducteur (210, 211, 212) fait partie d'un élément de commutation électromagnétique (230, 240).

3. Etage triphasé de sortie de puissance selon la revendication 1,
**caractérisé par** :
un dispositif (270) pour la préparation d'une énergie d'allumage prédéterminée pour l'interrupteur semi-conducteur (251, 261).

4. Etage triphasé de sortie de puissance selon la revendication 1,
**caractérisé en ce que** :
un dispositif protecteur est monté parallèlement à chaque interrupteur semi-conducteur.

5. Etage triphasé de sortie de puissance pour la commande d'au moins une charge, en particulier d'un moteur triphasé, avec un premier, un deuxième et un troisième conducteurs (210, 211, 212) pouvant être reliés à un dispositif d'alimentation en courant triphasé côté entrée, au moins un contact de commutation (231, 232, 242) pouvant être commandé étant affecté à chaque conducteur pour l'ouverture et la fermeture du conducteur correspondant, au moins deux contacts de commutation étant commandés indépendamment l'un de l'autre, et avec en outre un dispositif inverseur (280) monté entre deux conducteurs, comprenant deux deuxièmes éléments de commutation (290, 295) pouvant être commandés indépendamment l'un de l'autre, présentant chacun des premier et deuxième contacts de commutation, les premiers contacts de commutation (291, 296) des deuxièmes éléments de commutation (290, 295) étant reliés au premier conducteur (210) et les deuxièmes contacts de commutation (292, 297) des deuxièmes éléments de commutation (290, 295) à l'autre conducteur (212), et une interruption du flux de courant par les deux conducteurs (210, 212) étant obtenue dans une position prédéfinie des premiers et deuxièmes contacts de commutation,
**caractérisé en ce que** :
un interrupteur semi-conducteur respectif (251, 261) est relié aux deuxième et troisième conducteurs (211, 212),
entre les deuxième et troisième conducteurs, un premier élément de commutation (240) est relié à des premier et deuxième contacts de commutation (241, 242),
le premier contact de commutation (241) étant monté en parallèle à un des interrupteurs semi-conducteurs (251) et le deuxième contact de commutation (242) en parallèle à l'autre interrupteur semi-conducteur (261),
les premiers contacts de commutation (291, 296) des deux deuxièmes éléments de contact (290, 295) du dispositif inverseur (280) étant reliés au premier conducteur (210) et les deuxièmes contacts de commutation (292, 297) des deux deuxièmes éléments de contact (290, 295) étant reliés au troisième conducteur (212),
**en ce que** un troisième élément de commutation (230) est prévu avec des premier et deuxième contacts de commutation (231, 232), et
**en ce que** le premier contact de commutation (231) est relié au premier conducteur (210) et le deuxième contact de commutation (232) au deuxième conducteur (211).

6. Etage triphasé de sortie de puissance selon l'une des revendications 1 à 5,
**caractérisé en ce que** :
les éléments de commutation sont des relais.

7. Etage triphasé de sortie de puissance selon l'une des revendications 1 à 6,
**caractérisé en ce que** :
un circuit protecteur (220 ; 430) contre les surtensions est monté entre les trois conducteurs côté entrée.

8. Etage triphasé de sortie de puissance selon l'une des revendications précédentes,
**caractérisé par** un dispositif de commande (405) programmable pour la commande des éléments de commutation et des interrupteurs semi-conducteurs.

9. Etage triphasé de sortie de puissance selon l'une des revendications précédentes,
**caractérisé par** un dispositif de surveillance (405) pour la surveillance du sens de marche d'au moins un moteur triphasé connecté, des courants circulant dans les conducteurs et/ou des tensions de sortie appliquées entre les conducteurs, le dispositif de commande commandant les éléments de commutation et/ou interrupteurs semi-conducteurs respectifs en réaction au dispositif de surveillance.
